Europäisches Patentamt

European Patent Office

Office européen des brevets

(11) Publication number: **0 219 966 B1**

# EUROPEAN PATENT SPECIFICATION

(45) Date of publication of patent specification: **18.03.92**

(51) Int. Cl.5: **C30B 15/24**, C30B 15/14, C30B 15/30

(21) Application number: **86306952.2**

(22) Date of filing: **09.09.86**

(54) Process for pulling a crystal.

(30) Priority: **11.09.85 JP 199377/85**

(43) Date of publication of application:
**29.04.87 Bulletin 87/18**

(45) Publication of the grant of the patent:
**18.03.92 Bulletin 92/12**

(84) Designated Contracting States:
**DE FR GB**

(56) References cited:
**US-A- 4 167 554**

**JOURNAL OF CRYSTAL GROWTH, vol. 65, no. 1/3, December 1983, pages 237-242, Elsevier Science Publishers B.V. (North-Holland Physics Publishing Division), Amsterdam, NL; D. MATEIKA et al.: "Czochralski growth by the double container technique"**

**PATENT ABSTRACTS OF JAPAN, vol. 7, no. 86 (C-161)[1231], 9th April 1983; & JP-A-58 15 097 (TOKYO SHIBAURA DENKI K.K.) 28-01-1983**

**PATENT ABSTRACTS OF JAPAN, vol. 7, no.**

**34 (C-150)[1179], 10th February 1983; & JP-A-57 188 500 (TOKYO SHIBAURA DENKI K.K.) 19-11-1982**

(73) Proprietor: **SUMITOMO ELECTRIC INDUS-TRIES, LIMITED**
**5-33, Kitahama 4-chome Chuo-ku Osaka(JP)**

(72) Inventor: **Tada, Kohji, c/o Osaka Works Sumitomo Electric Ltd., 1-3, Shimaya 1-chome Konohana-ku, Osaka(JP)**
Inventor: **Kotani, Toshihiro, c/o Osaka Works Sumitomo Electric Ltd., 1-3, Shimaya 1-chome Konohana-ku, Osaka(JP)**

(74) Representative: **Cross, Rupert Edward Blount et al**
**BOULT, WADE & TENNANT 27 Furnival Street London EC4A 1PO(GB)**

Rank Xerox (UK) Business Services

## Description

This invention relates to pulling a crystal from a melt of raw material, i.e. the technique usually called Czachralski pulling.

It is known to control the temperature distribution in a melt of raw material with the aid of a baffle plate which suppresses convection in the melt. In particular, it is known from the Journal of Crystal of Growth volume 10 pages 91-96 (1971) and laid open Japanese Patent Application No. 3612/1972 to provide a baffle plate substantially vertically with respect to the pulling direction of the crystal and positioned between a quarter and three-quarters of the depth of the raw material melt from the bottom of the crucible. However, seeding of the crystal and growth of the shoulder or conical part of the pulled crystal are rather unstable and the diameter or cross-section of the crystal fluctuates undesirably.

It is known from laid open Japanese Patent Application No. 64482/1976 to provide a baffle plate which has a central opening and is floated on the melt such that a single crystal is pulled through the opening. The baffle plate proposed in this publication may be made of boron nitride, quartz, graphite, silicon nitride or silicon carbide.

It is known from laid open Japanese Patent Application No. 15097/1983 to provide a baffle plate which is supported at a suitable position by a guide pin.

The baffles provided by the techniques described in these publications are intended to suppress fluctuation in the diameter of the pulled crystal. The pulling of a straight trunk of the crystal can be performed in a stable manner but it is not possible to prevent instability in the growing phase from seeding to the shoulder of the pulled crystal. The crystal growth tends to be abnormal and the crystal structure tends to be polycrystalline.

Other proposals for the use of baffles are made in laid open Japanese Patent Application No. 188500/1982 and the Journal of Crystal Growth volume 65 pages 237-242 (1983). However in none of the techniques described in the foregoing references are there disclosed satisfactory proposals for pulling a crystal and achieving stable growth from seeding to the ultimate trunk part of the crystal.

It is accordingly the object of the present invention to provide an improved technique for the pulling of a single crystal, in particular with the reduction of crystal defects. In particular the present invention provides an improved technique for controlling the radial temperature distribution of a melt as the diameter of a pulled crystal at the solid liquid interface increases. The invention facilitates the stabilization of growth and the flattening of the solid-liquid interface throughout the process of pulling.

According to the invention, a process of pulling a crystal from a melt of raw material comprises disposing a baffle such that the melt inside the baffle is in communication through a lower end of the baffle with melt outside the baffle, characterized in that the shape of the baffle and relative movement between the baffle and the surface of the melt are such that the surface diameter or area of the melt inside the baffle increases as the diameter or cross-section of the pulled crystal at the solid-liquid interface increases.

BRIEF DESCRIPTION OF THE DRAWINGS

In the accompanying drawings;
Figure 1 is a simplified cross-sectional view of an apparatus for pulling a crystal;
Figure 2 is a schematic illustration of a baffle;
Figure 3 is a graph showing a change of the diameter of a melt surface inside a baffle plate;
Figure 4 is a graph showing the relationship between the length of a crystal and the diameter of a crystal:
Figure 5 comprises three schematic views of the position of the baffle plate in various stages in the pulling of a crystal;
Figure 6 illustrates the temperature distribution of a melt in a crucible without any baffle plate;
Figure 7 illustrates the temperature distribution of a melt when a cylindrical baffle is used;
Figure 8 illustrates the temperature distribution of a melt during the use of a baffle plate which comprises an upper cylinder and a lower funnel; and
Figure 9 illustrates the relationship between the seeding of the crystal and the temperature distribution in the melt.

DETAILED DESCRIPTION

The present invention is preferably put into practice by the use of a baffle of which the diameter or cross-section varies, the baffle having a part corresponding to a funnel or truncated cone which may vary in diameter linearly or otherwise. The diameter of the cone or funnel preferably increases in the upward direction and the baffle is preferably provided, at its upper end, with a straight trunk part. The baffle is preferably made of a material which has both chemical and thermal resistance to a melt of raw material. A baffle may for example be made of carbon, sintered boron nitride, pyrolytic boron nitride, aluminium nitride, quartz, silicon carbide, or silicon nitride.

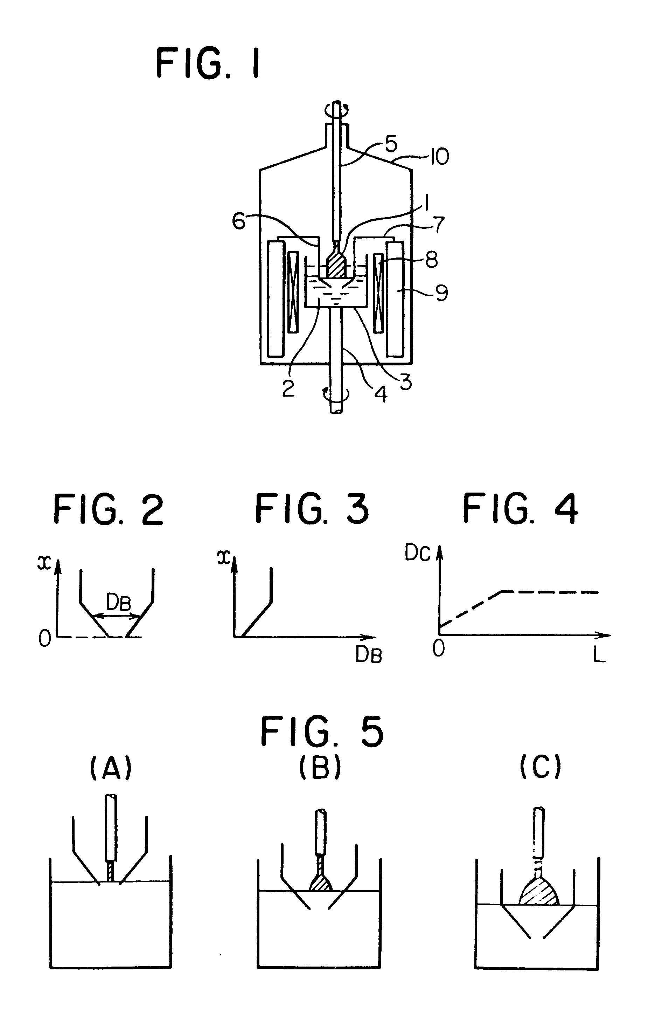

Figure 1 illustrates in cross-section an apparatus for pulling a crystal 1 from a melt 2 of raw material.

A crucible 3 containing a melt 2 of raw material is supported at the centre of a chamber 10 by means of a shaft 4. A heater 8 and heat insulating material 9 are disposed around the crucible 3 to heat the raw material. A baffle plate 6 extends into the melt 2 so as to define a pulling zone which is partitioned from the remainder of the melt, the melt inside the confine of the baffle and outside the baffle communicating through the lower, open end of the baffle 6. The baffle has a straight trunk from which depends a tapered or conical part terminating in the aforementioned lower, narrow end.

Into the baffle can extend a shaft 5, which can be moved downwardly to engage the surface of the melt inside the baffle and can be rotated so as to pull a crystal from the melt. Although not shown explicitly in Figure 1, both the pulling shaft 5 and the supporting shaft 4 can move vertically while they rotate so that the pulling shaft may draw the crystal from the melt and so that the baffle and the crucible can be moved relative to each other. Thus in this embodiment of the invention the shaft 4 constitutes a means for moving the baffle relative to the surface of the melt. Owing to the shape of the baffle, the surface area of the melt within the baffle may be varied according to the position of the tapered or conical part of the baffle relative to the surface of the melt. Alternatively, the baffle 6 could be movable directly.

Figure 2 is a schematic view of a baffle comprising an upper straight trunk and a lower funnel. Where x represents a height dimension from a zero datum represented by the lower end of the funnel, the variation of the diameter (for a circular cross-section baffle) $D_B$ varies with x as shown in Figure 3. The pulled crystal is, according to the invention, to be grown such that the diameter lateral dimension $D_C$ of the crystal at the solid liquid interface is gradually increased from the size of an original seed crystal to desired diameter, after which the crystal is grown normally in the form of a circular cylinder. The increase in the diameter of the crystal from seeding is shown in Figure 4 which is a graph of crystal diameter against length.

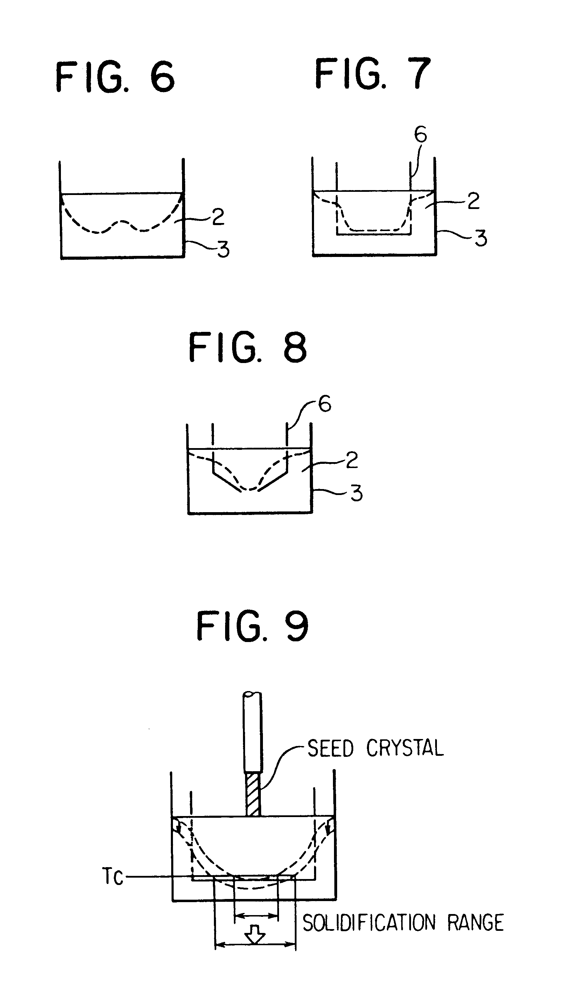

Figure 5 comprises various views showing the relationship of the baffle to the surface of the melt at various stages during the growth of the crystal. Stage (A) illustrates the crystal at or just after seeding; at this stage the baffle is (in this example) at a relatively high position relative to the melt and the diameter of the baffle at the solid-liquid interface is at or near a minimum. Stage (B) occurs during the formation of a shoulder or cone part: the baffle has been lowered to increase the diameter at the surface of the melt. Stage (C) corresponds to the formation of the straight trunk part of the pulled crystal. At this stage the baffle has been moved downwardly to provide a maximum diameter of the surface of the melt within the baffle. Preferably the movement of the baffle is such that the inner diameter $D_B$ of the baffle bears a substantially fixed proportion to the diameter $D_C$ of the pulled crystal. The effective diameter of the baffle plate is preferably adjusted during the formation of the shoulder or cone part of the crystal.

Figure 6 shows in broken line the temperature distribution of the melt 2 in a crucible 3 wherein no baffle plate is employed. Figure 7 and figure 8 illustrate the temperature distribution resulting from the use of different forms of baffle plate.

The temperature distribution may vary with the position or number of holes made in the baffle. However, in general, the temperature distribution of the melt in the radial direction can be controlled by changing the inner diameter of the baffle during pulling.

When the racial temperature distribution is controlled, a rapid change of the crystal diameter and concave shaping of the solid-liquid interface takes place. Immediately after the seeding of the crystal, if a baffle with an inner diameter much larger than the diameter of the seed crystal is used, the radial temperature distribution is quite flat within the baffle plate as shown in Figure 9. If the crystal solidifying temperature ($T_C$) is higher than the temperature in the melt, the crystal diameter becomes larger than the size of the seed crystal. However, if the temperature of the melt is higher than the solidifying temperature of the crystal, the crystal diameter becomes smaller. If the baffle having an inner size somewhat larger than the size of the seed crystal is employed, the extent of the flat part of the radial temperature distribution becomes smaller and the fluctuation range of the crystal diameter is decreased. This is somewhat different from the effect in the system described in the Journal of Crystal Growth volume 65 pages 237-242 (1983) as mentioned above. In that system the radial temperature of distribution is of a steep V-type within the baffle plate and a stable increase of the crystal diameter is difficult.

Thus if the temperature of the melt is lowered the crystal diameter is increased but the temperature at the central part is lowered so that the solid-liquid interface tends to be concave at the central part. In this case therefore it is necessary to increase gradually the inner diameter of the baffle and thus to increase the crystal diameter.

The present invention permits a variable control of the radial temperature distribution of the melt during pulling of the crystal and, depending upon the diameter of the crystal, an optimum distribution can be attained. Consequently it is possible to accomplish stabilization of the crystal growth as well as flattening of the solid-liquid interface throughout the process of pulling thus resulting in uniform growth of a single crystal. The shape of the baffle plate may be quite simple and complicated working is not required. Moreover, the method is generally available for any growth of a single crystal using the pulling method.

Example

1.6 kg of GaAs crystal was charged in a quartz crucible of 101.6 mm in diameter. A baffle was made of boron nitride with a straight trunk length of 40 mm, an inner diameter of 60 mm, a tapered part height of 25 mm and a lower end diameter of 10 mm. A seed crystal 4 mm square was used. A pulling furnace was filled with nitrogen gas under a pressure of 15 atm and pulling was carried out at a pulling speed of 10 mm/H. The pulling shaft rotating at 5 rpm and the crucible being rotated at 12 rpm. This operation started while the baffle was immersed in the melt by 5 mm at seeding and thereafter the immersion was gradually continued until the length and diameter of the pulled crystal were respectively 20 mm and 50 mm. When the crystal diameter reached the straight trunk part of 50 mm, the baffle was stopped to hold the diameter of the melt surface with the baffle at 60 mm and pulling was continued. The relative movement of the baffle and the crucible was performed by fixing the baffle and gradually raising the crucible. The pulled crystal produced had a diameter of 50 mm and a weight of about 1.5 kg. No sudden fluctuation of diameter nor dendritic growth were discovered.

Examination by x ray topography showed that the solid-liquid interface of the crystal was substantially flat and there was no irregular striation due to temperature fluctuation of the melt.

The invention is applicable to the pulling of crystals of for example, Si, Ge, GaAs, InP, InAs, ACAs, CdTe, CdSe, ZnTe, HgTe, MnTe, $Gd_3Ga_5O_{12}$, $Bi_{12}SiO_{20}$ and $LiNbO_3$ from raw material melts.

## Claims

1. A process of pulling a crystal (1) from a melt (2) of raw material, comprising disposing a baffle (6) such that the melt inside the baffle is in communication through a lower end of the baffle with the melt outside the baffle, characterized in that the shape of the baffle and relative movement between the baffle and surface of the melt are such that the surface diameter or area of the melt inside the baffle increases as the diameter or cross-section of the pulled crystal at the solid-liquid interface increases.

2. The process according to claim 1 in which the baffle (6) comprises a tapered tubular or truncated conical part.

3. A process according to claim 2 in which the baffle (6) includes a part of constant cross-section joined to the tubular part.

## Revendications

1. Procédé de tirage d'un cristal (1) à partir d'une masse en fusion (2) d'un matériau brut, comportant la mise en place d'un déflecteur (6) tel que la masse en fusion à l'intérieur du déflecteur soit en communication par une extrémité inférieure du déflecteur avec la masse en fusion à l'extérieur du déflecteur, caractérisé en ce que la forme du déflecteur, et le déplacement relatif entre le déflecteur et la surface de la masse en fusion sont tels que le diamètre de surface, ou aire de la masse en fusion à l'intérieur du déflecteur s'accroisse comme s'accroît le diamètre ou section droite du cristal tiré à l'interface solide liquide.

2. Procédé suivant la revendication 1, où le déflecteur (6) comporte une partie tubulaire fuselée ou tronconique.

3. Procédé suivant la revendication 2, où le déflecteur (6) comprend une partie à section transversale constante, réunie à la partie tubulaire.

## Patentansprüche

1. Verfahren zur Züchtung eines Kristalls (1) aus einer Rohmaterialschmelze (2), mit Anordnung eines Baffles (6), so daß die Schmelze innerhalb des Baffles über ein unteres Ende des Baffles mit der Schmelze außerhalb des Baffles in Verbindung steht, dadurch gekennzeichnet, daß die Form des Baffles und die Relativbewegung zwischen dem Baffle und der Oberfläche der Schmelze so gewählt sind, daß der Oberflächendurchmesser oder die Fläche der Schmelze innerhalb des Baffles zunimmt, während der Durchmesser oder Querschnitt des gezüchteten Kristalls an der Grenzfläche zwischen Feststoff und Flüssigkeit zunimmt.

2. Verfahren nach Anspruch 1, bei welchem das Baffle (6) ein verjüngtes röhrenförmiges oder kegelstumpfförmiges Teil umfaßt.

3. Verfahren nach Anspruch 2, bei welchem das Baffle (6) ein Teil konstanten Querschnitts aufweist, welches mit dem röhrenförmigen Teil

verbunden ist.

# FIG. 1

# FIG. 2

# FIG. 3

# FIG. 4

# FIG. 5

(A)     (B)     (C)

# FIG. 6

# FIG. 7

# FIG. 8

# FIG. 9